# EUROPÄISCHE PATENTSCHRIFT

(11) **EP 1 131 987 B1**
(45) Veröffentlichungstag und Bekanntmachung des Hinweises auf die Patenterteilung: **13.10.2004**
(21) Anmeldenummer: 99960877.1
(22) Anmeldetag: 09.11.1999
(51) Int. Cl.: H05K 7/14

(54) **AUFBAUSYSTEM FÜR ELEKTRISCHE FLACHBAUGRUPPEN MIT ZENTRIERKONTAKTTEILEN AN FRONTELEMENTEN UND SEPARATEN AUFNAHMEKONTAKTTEILEN, INSBESONDERE MIT KONTAKTMESSERN IM BAUGRUPPENTRÄGER**
MODULAR SYSTEM FOR ELECTRICAL PRINTED-CIRCUIT BOARDS WITH CENTERING CONTACTS ON FRONT ELEMENTS AND SEPARATE LOCATING CONTACTS, NOTABLY WITH CONTACT BLADES IN THE RACK ASSEMBLY
SYSTEME DE MONTAGE POUR CARTES IMPRIMEES ELECTRIQUES AVEC CONTACTS DE CENTRAGE SUR DES ELEMENTS FRONTAUX ET CONTACTS DE RECEPTION DISTINCTS EN PARTICULIER AVEC DES LAMES DE CONTACT DANS LE CHASSIS

(30) Priorität: 09.11.1998 DE 19851516
(43) Veröffentlichungstag der Anmeldung: 12.09.2001
(73) Patentinhaber: Rittal Electronic Systems GmbH & Co. KG, 90542 Eckental (DE)
(72) Erfinder: KURRER, Siegfried, D-90449 Nürnberg (DE); SCHAFFER, Kurt-Michael, D-90542 Eckental (DE)
(74) Vertreter: Fleck, Hermann-Josef, Dr.-Ing.
(86) Internationale Anmeldenummer: PCT/DE1999/003572
(87) Internationale Veröffentlichungsnummer: WO 2000/028799

(56) Entgegenhaltungen:
- DE-A- 3 624 883

## Beschreibung

Das erfindungsgemäße Aufbausystem enthält einen Baugruppenträger für den Einschub von elektrischen Flachbaugruppen. Dieser weist zumindest gegenüberliegende Querverbindungsschienen aus elektrisch leitendem Material auf, welche paarweise gegenüber liegend mit Führungsschienen belegt sind. Ein derartiger Baugruppenträger stellt Volumenelemente bereit, welche zum Einschub von elektrischen Flachbaugruppen vorgesehen sind. Diese werden auch als Einbauplätze bezeichnet und sind in der Regel parallel nebeneinander angeordnet. In diese können elektrische Flachbaugruppen eingeschoben werden, welche dann ebenfalls parallel nebeneinander liegen.

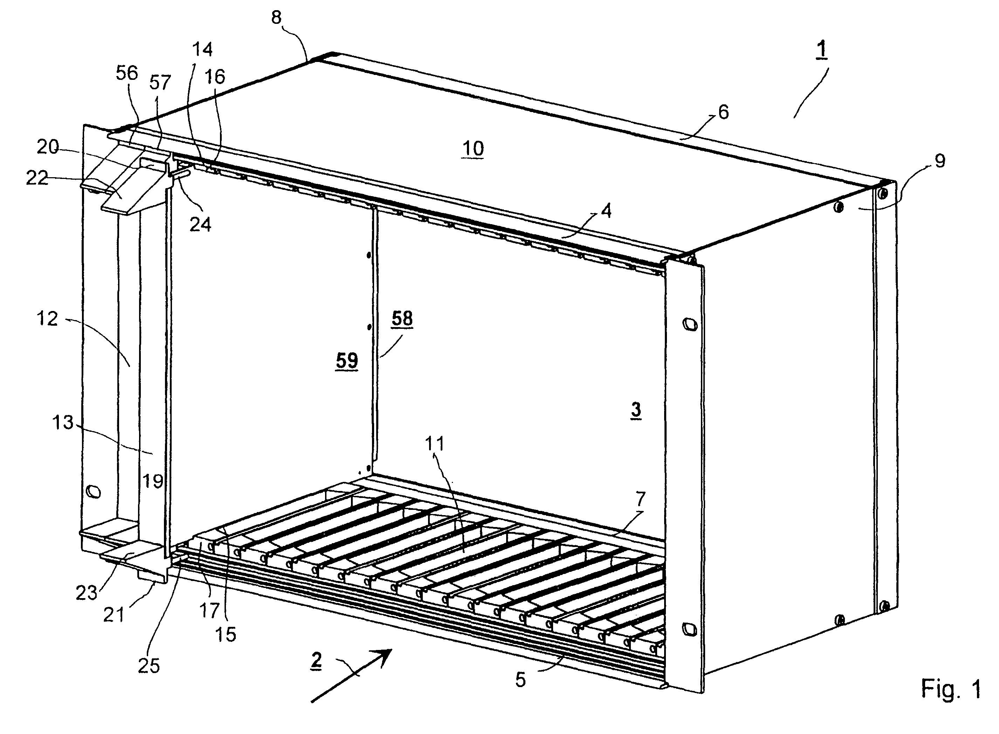

Ein möglicher standardmäßiger Grundaufbau eines Baugruppenträgers 1 ist in Figur 1 beispielhaft dargestellt. Der Aufnahmeraum für Flachbaugruppen wird begrenzt von gegenüberliegenden Querverbindungsschienen aus elektrisch leitendem Material. Im Beispiel der Figur 1 sind zwei untere Querverbindungsschienen 5,7 und zwei gegenüberliegende, obere Querverbindungsschienen 4,6 vorhanden. Die Querverbindungsschienen 4,5 begrenzen die Vorderseite des Baugruppenträgers 1, d.h. die zum Einsetzen elektrischer Flachbaugruppen vorgesehene Einschubseite 2. Die beiden Querverbindungsschienen 6,7 begrenzen die Rückwandseite 3 des Baugruppenträgers 1, welche z.B. durch eine Rückwandleiterplatte abgeschlossen sein kann. Die Querverbindungsschienen 4,5,6,7 können an den Seiten z.B. im Inneren eines Schaltschrankes montiert sein. In Figur 1 sind vertikale Seitenwandbleche 8,9 vorhanden, mit denen die Querverbindungsschienen seitlich verschraubt sind. Schließlich ist die Ober- bzw. Unterseite des Baugruppenträgers 1 mit einem oberen bzw. unteren Abdeckblech 10,11 verschlossen.

Zum Verschluß der Einschubseite 2 des Baugruppenträgers 1 sind sogenannte Frontelemente vorgesehen, welche den einzelnen Einbauplätzen im Inneren des Baugruppenträgers zugeordnet, an deren Breite angepaßt und aufsteck- bzw. abziehbar ausgestaltet sind. Diese Verschlußmöglichkeit kann unabhängig davon sein, ob der hinter einem Frontelement liegende Einbauplatz mit einer elektrischen Flachbaugruppe belegt ist oder nicht. Es können somit einerseits freie Einbauplätze mit einem auf die Einschubseite 2 des Baugruppenträgers 1 aufgesetzten Frontelement in der Art einer Leerplatzabdeckung verschlossen werden. Andererseits können elektrische Flachbaugruppen an einer Stirnseite mit einem Frontelement versehen sein, so daß nach deren Einschub in den Baugruppenträger 1 das Frontelement den entsprechenden Einbauplatz auf der Einschubseite 2 in der gleichen Weise abdeckt.

In Figur 1 sind für die beiden Einbauplätze 56,57 an der linken Seite des Baugruppenträgers 1 beispielhaft Frontelemente 12,13 vorhanden. Diese sind mehrteilig ausgeführt. So enthält das Frontelement 13 eine vertikale Frontplatte 19 aus elektrisch leitendem Material. Deren untere und obere Stirnseiten sind mit je einem Endstück 20,21 versehen, das in der Regel ebenfalls aus einem elektrisch leitenden Material besteht. An diesen Endstücken sind beispielhaft sogenannte Hebelziehgriffe 22,23 drehbar gelagert. Diese können von einer Person durch Schwenkbewegungen so bedient werden, daß ein Aufsetzen bzw. Abheben eines Frontelementes 12,13 oder ein Einschieben bzw. Herausziehen einer mit einem Frontelement verbundenen elektrischen Flachbaugruppe auf einfache Weise möglich ist.

Im Beispiel der Figur 1 ist das Frontelement 12 bereits vollständig abdeckend auf den dahinter liegenden Einbauplatz 56 aufgeschoben und liegt in der Ebene der Einschubseite 2 des Baugruppenträgers 1. Das Frontelement 13 des daneben befindlichen Einbauplatzes 57 ist beispielhaft fest mit einer Flachbaugruppe 59 verbunden. Die Verbindung erfolgt dabei vorteilhaft mit Hilfe der beiden Endstücke 20,21. Die Flachbaugruppe ist bereits weitgehend in den Einbauplatz 57 eingeschoben. Nach einem vollständigen Einschub in den Einbauplatz 57 würde das Frontelement 13 bündig neben dem Frontelement 12 ebenfalls in der Ebene der Einschubseite 2 zu liegen kommen.

Zur Führung von Flachbaugruppen sind Führungsschienen vorgesehen, welche vorteilhaft pro Einbauplatz paarweise gegenüberliegend im Einbauraum zwischen den Querverbindungsschienen angeordnet sind. Im Beispiel der Figur 1 ist der gesamte Einbauraum zwischen den oberen und unteren Querverbindungsschienen 4,6 und 5,7, d.h. die Summe aller Einbauplätze bereits mit solchen Paaren von Führungsschienen belegt. So wird die Flachbaugruppe 59 an der oberen und unteren Stirnseite von den gegenüber liegenden Führungsschienen 14,15 geführt.

Beim Einschieben von Frontelementen bzw. Einheiten aus Frontelementen und elektrischen Flachbaugruppen sollten diese Elemente insbesondere unmittelbar vor Erreichen des vollständig eingeschobenen Zustandes in Einschubrichtung zentriert werden. Hierdurch wird ein versehentlicher seitlicher Versatz insbesondere der Frontelemente vermieden, wodurch das vollständige Einschieben zumindest behindert werden könnte. Diese Zentrierung ist besonders dann notwendig, wenn benachbarte Einbauplätze bereits mit Frontelementen abgedeckt sind.

Schließlich sollten Frontelemente insbesondere dann, wenn diese und deren Teile weitgehend aus elektrisch leitenden Materialien bestehen, mit dem Baugruppenträger sicher elektrisch leitend kontaktierbar sein. Bei Kontaktierungen wird zwischen verschiedenen Arten unterschieden.

Eine erste Art kann als Schutzkontaktierung bzw. Ground Kontaktierung bezeichnet werden. Hiermit können z.B. hohe Fehlerströme von Frontelementen auf den Baugruppenträger abgeleitet und dann von nachgeschalteten Netzschutzeinrichtungen, z.B. Lasttrennschaltern oder Fehlerstromschutzschaltern, mit einer den Personenschutz gewährleistenden Geschwindigkeit unterbrochen werden. Eine Schutzkontaktierung soll besonders dann wirksam sein, wenn alle Flachbaugruppen in einem Baugruppenträger elektrisch aktiviert sind.

Eine weitere Art der Kontaktierung dient zur Ableitung von elektrostatischen Spannungen und kann als ESD Kontaktierung (electro static discharge) bezeichnet werden. Hiermit können z.B. statische Potentiale von Frontelementen auf den Baugruppenträger und dessen Masseanschluß abgeleitet werden. Eine ESD Kontaktierung soll besonders dann wirksam sein, wenn Flachbaugruppen in einen Baugruppenträger eingeschoben bzw. herausgezogen werden.

Aus der EP 0 579 859 B1 ist eine Flachbaugruppe mit Führungsstiften zum positionsgenauen Einschub in einen Baugruppenträger bekannt. Dabei sind zur Zentrierung an den Außenseiten der Eckmontagekörper einer Flachbaugruppe zwei Führungsstifte vorhanden, welche sich beim Einschieben an den Seitenflanken des gegenüberliegenden Kopfendes einer Längsführungsschiene abstützen. Zusätzlich ist zwischen den Führungsstiften ein Massekontaktstift angeordnet, welcher beim Einschieben der Flachbaugruppe in eine, mit einer Massekontaktfeder belegten Kodierkammer an der Stirnseite des gegenüberliegenden Kopfendes der Längsführungsschiene eintaucht.

Aus der WO 96/42187 ist ein Frontsystem für eine Flachbaugruppe mit Aktiv-Passiv-Schaltung bekannt. Zur Zentrierung weist das Endstück der Flachbaugruppe einen Führungsstift auf, welcher zum Eingriff in eine gegenüberliegende Führungsbohrung vorgesehen ist. Diese Anordnung weist keine Elemente zur elektrischen Schutzkontaktierung zwischen Frontelement und Querverbindungsschienen auf.

Aus der WO 97/49271 ist ein Baugruppenträger für elektrische Flachbaugruppen bekannt. Die Flachbaugruppen weisen an einer Längsseite einen Kontaktstreifen in der Art einer Leiterbahn auf, der über einen elektrischen Widerstand mit einer metallischen Frontplatte der Flachbaugruppe verbunden ist. Der Kontaktstreifen tritt während eines Einschubs der Flachbaugruppe in den Baugruppenträger schleifend in einen elektrisch leitenden Kontakt mit einer Kontaktfeder, welche in einer Führungsschiene insbesondere im Kopfbereich integriert und leitend mit der dazugehörigen Querverbindungsschiene verbunden ist. Die Frontplatte der Flachbaugruppe weist ferner eine Schraube auf, womit unter Umgehung des Widerstandes eine direkte elektrisch leitende Verbindung zum Baugruppenträger im eingesteckten Zustand der Flachbaugruppe möglich ist. Ausführungen von Führungsschienen mit Schleifkontaktfedern sind z.B. aus DE 36 24 883 oder DE GM 295 09 185 bekannt.

Aus der DE 36 24 839 C2 ist schließlich eine Führungsschiene für Flachbaugruppen bekannt. Deren Führungsnut ist von Seitenwänden begrenzt, wobei eine Seitenwand abschnittsweise vom Nutgrund getrennt und derart als glockenkurvenförmige Blattfeder gestaltet ist, daß die Breite der Führungsnut verjüngt ist.

Der Erfindung liegt die Aufgabe zu Grunde, ein Aufbausystem mit einem Baugruppenträger zum Einschub von elektrischen Flachbaugruppen anzugeben, welches ein leichte Nachrüstbarkeit von Kontaktteilen für eine Schutzkontaktierung von Frontelementen ermöglicht. Der Erfindung liegt die weitere Aufgabe zu Grunde, zusätzlich eine besonders einfach integrierte und ebenfalls leichte nachrüstbare Ableitung von statischen Spannungspotentialen zu ermöglichen.

Die Aufgabe wird gelöst mit einem Aufbausystem gemäß den nebengeordneten Ansprüchen 1 und 12. Weitere Ausführungsformen der Erfindung sind in den Unteransprüchen enthalten.

Die Erfindung wird desweiteren anhand der in den nachfolgend kurz angeführten Figuren dargestellten Ausführungsbeispielen weiter erläutert. Dabei zeigt
- FIG 1: eine oben bereits weitgehend erläuterte, perspektivische Seitenansicht auf ein Aufbausystem mit Baugruppenträger und Frontelementen,
- FIG 2a,2b,2c: eine perspektivische Draufsicht auf eine beispielhafte erste Ausführungsform einer Führungsschiene und einem Aufnahmekontaktteil mit Kontaktmittel für eine Ground-Kontaktierung gemäß der Erfindung,
- FIG 3a,3b,3c,3d: eine der Figur 2 entsprechende Draufsicht auf eine beispielhafte zweite Ausführungsform von Führungsschiene und Aufnahmekontaktteil mit Kontaktmittel, welche ein zusätzliches Verbindungsmittel zur Querverbindungsschiene aufweist,
- FIG 4: eine perspektivische Draufsicht auf einen Ausschnitt eines Frontelements, einer Querverbindungsschiene und einer Führungsschiene mit eingelegtem Aufnahmekontaktteil gemäß den Figuren 3a,3b,3c,3d,
- FIG 5: eine Schnittdarstellung durch ein Aufnahmekontaktteil mit Kontaktmittel gemäß den Figuren 3b,3c,
- FIG 6: eine perspektivische Seitenansicht einer weiteren Ausführung eines Aufnahmekontaktteils,
- FIG 7: eine perspektivische Seitenansicht einer weiteren Ausführung eines Aufnahmekontaktteils,
- FIG 8a,8b: eine perspektivische Draufsicht auf eine beispielhafte Führungsschiene und ein Aufnahmekontaktteil, welches gemäß einer weiteren Ausführungsform der Erfindung zusätzlich ein Kontaktmesser für eine ESD-Kontaktierung aufweist, und
- FIG 9: eine perspektivische Draufsicht auf eine Führungsschiene mit eingelegtem Aufnahmekontaktteil gemäß den Figuren 8a,8b.

In der oben bereits weitgehend erläuterten Figur 1 ist das Frontelement 13 am Einbauplatz 57, welches beispielhaft mit der Flachbaugruppe 59 verbunden ist, bereits gemäß der Erfindung mit in Richtung auf die Einschubseite 2 des Baugruppenträgers 2 vorstehenden Zentrierkontaktteilen 24,25 versehen. Diese sind jeweils an einem oberen und unteren Endstück 20,21 angebracht, wobei die Endstücke 20,21 an den stirnseitigen Enden der Frontplatte 19 des Frontelements 13 fixiert sind. Die Endstücke dienen ebenfalls zur Halterung eines oberen und unteren Hebelziehgriffes 22,23, womit eine leichte Ein- bzw. Aushebelung der Einheit aus Frontelement 13 und Flachbaugruppe 58 möglich ist. Die Endstücke mit den Zentrierkontaktteilen bestehen ebenso wie Frontplatte und Querverbindungsschienen aus elektrisch leitendem Material. Die oberen und unteren Querverbindungsschienen 4,6 und 5,7 sind auf den Innenseiten, welche den zwischenliegenden Einbauplätzen zugewandt sind, mit Führungsschienen belegt. Dabei ist jedem Einbauplatz je ein Paar von gegenüber liegenden Führungsschienen zugeordnet, in denen die Kanten einer zwischenliegenden Flachbaugruppe geführt werden können. Im Beispiel der Figur 1 sind dem Einbauplatz 57 die Führungsschienen 14,15 zugeordnet.

Gemäß der Erfindung weist jede Führungsschiene zumindest ein Aufnahmekontaktteils auf, das wiederum einem Zentrierkontaktteil am dazugehörigen Frontelement zugeordnet ist. In Figur 1 sind in die Führungsschienen 14,15 die Aufnahmekontaktteile 16,17 eingelegt und den Zentrierkontaktteilen 24,25 am Frontelement 13 zugeordnet. Bei Einschub der Flachbaugruppe 59 in den Einbauplatz 57 und der dabei erfolgenden Auflage des Frontelements 13 auf die Einschubseite 2 des Baugruppenträgers 1, treten die Zentrierkontaktteile 24,25 am Frontelement 13 in einen elektrisch niederohmigen und eine hohe Stromtragefähigkeit aufweisenden Kontakt mit den Aufnahmekontaktteilen 16,17 an den Führungsschienen 14,15. Hierdurch wird eine Schutzkontaktierung zwischen Frontelement 13, Flachbaugruppe 59 und Baugruppenträger 1 hergestellt.

Die Erfindung weist auf Grund der zweiteiligen, getrennten Ausführung von Führungsschienen und Aufnahmekontaktteilen den Vorteil auf, daß bereits in einem Baugruppenträger befindliche Führungsschienen u.U. individuell mit Aufnahmekontaktteilen nachgerüstet werden können. Ein besonderer Vorteil wird weiter darin gesehen, daß Führungsschienen und Aufnahmekontaktteilen aus unterschiedlichen Materialien bestehen können. So können die Führungsschienen kostengünstig aus einem elektrisch nicht leitendem Material gefertigt sein, z.B. Kunststoff, während die einlegbaren Aufnahmekontaktteile aus einem zumindest oberflächlich elektrisch leitenden Material, insbesondere einem Metall, bestehen.

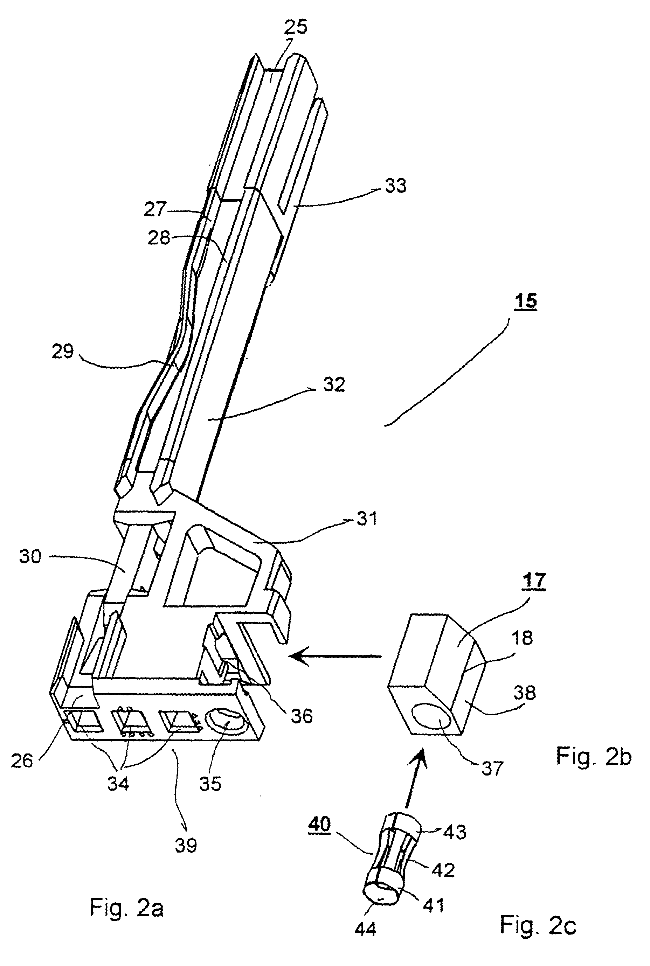

Mittels der Figuren 2a, 2b und 2c wird nachfolgend eine beispielhafte erste Ausführungsform der Erfindung näher erläutert. Dabei zeigt Figur 2a eine perspektivische Draufsicht auf den Kopfbereich einer Führungsschiene, Figur 2b ein Aufnahmekontaktteil und Figur 2c ein vorteilhaftes, zusätzliches Kontaktmittel zur Einlage in das Aufnahmekontaktteil.

Die in Figur 2a ausschnittsweise dargestellte Führungsschiene 15 weist einen Kopfbereich 31 auf, an den sich ein schienenförmiger Verlängerungsbereich 32 anschließt. Auf deren Oberseiten befindet sich eine Führungsnut 25 für den Eingriff der Kante einer Flachbaugruppe. Diese kann über einen trichterförmigen Einführungsbereich 26 an der Stirnseite 39 des Kopfbereiches 31 in die Führungsnut 25 eingeführt werden, die durch eine linke, rechte Nutwand 27,28 begrenzt wird. Im Beispiel der Figur 2 ist die Nutwand 27 in einem Segment vom Nutgrund getrennt und als eingedrückter Federbereich 29 gestaltet. Eine solche Ausführung ist in DE 36 24 839 beschrieben. Ferner weisen Nutwände 27,28 und Nutgrund im Bereich 30 eine Unterbrechung auf. Hier kann eine ESD Kontaktfeder eingesetzt werden, wie dies z.B. in DE 3624883 oder DE GM 295 09 185 beschrieben ist. Schließlich geht im Beispiel der Figur 2 der Verlängerungsbereich 32 in ein separates, u.U. mehrteiliges Verlängerungsstück 33 über, das an den Verlängerungsbereich 32 ansteckbar ist. Diese Ausführung ist z.B. in WO 96/39013 beschrieben. An der Stirnseite 39 des Kopfbereiches 31 befinden sich ferner unterhalb des Einführungsbereiches 26 zum Eingriff von Kodierstiften dienende Kodierkammern 34.

Vorteilhaft weist jede Führungsschiene zumindest eine Halteeinrichtung zur Einlage eines Aufnahmekontaktteils 17 aus elektrisch leitendem Material auf. Diese ist bevorzugt als muldenförmige Aufnahmekammer 36 gestaltet, und bevorzugt am Kopfbereich 31 der Führungsschiene und in räumlicher Nähe zur Einschubseite 2 des Baugruppenträgers 1 angeordnet. Das Aufnahmekontaktteil ist einerseits auf einer Querverbindungsschiene niederohmig kontaktierbar und weist andererseits einen Kontaktbereich auf, welcher zur Kontaktierung eines bevorzugt stiftförmigen Zentrierkontaktteiles an einem Frontelement dient. Gemäß einer anderen, nicht dargestellten Ausführung kann die Halteeinrichtung z.B. Rastfedern aufweisen, welche vom Kopfbereich der Führungsschiene ausgehend ein Aufnahmekontaktteil z.B. an den Flanken umfassen.

Der Kontaktbereich kann bevorzugt in Form eines in das Aufnahmekontaktteil integrierten Kontakthohlraumes ausgeführt sein. Zum Zwecke der Vereinfachung wird bei der weiteren Erläuterung für den Begriff Kontaktbereich der Begriff Kontakthohlraum verwendet. Selbstverständlich kann der Kontaktbereich konstruktiv auch anders ausgeführt sein.

Bei der in Figur 1 dargestellten Ausführung wird die Aufnahmekammer 36 auch von einem Bereich der Stirnseite 39 des Kopfbereiches 31 begrenzt. Damit ein Zentrierkontaktteil in die Aufnahmekammer 36 und in ein gegebenenfalls darin eingelegtes Aufnahmekontaktteil 17 eintauchen kann, weist die Stirnseite 39 zusätzlich eine Aufnahmeöffnung 35 für ein Zentrierkontaktteil auf. Diese Ausführung hat den Vorteil, daß beim Eintauchen eines Zentrierkontaktteiles in die Aufnahmeöffnung 35 zumindest eine zentrierende Wirkung erzielt wird, selbst wenn in die Aufnahmekammer 36 kein Aufnahmekontaktteil 17 eingelegt sein sollte.

Figur 2b zeigt eine erste Ausführung eines Aufnahmekontaktteiles 17. Dieses kann, durch einen Pfeil symbolisiert, in die Aufnahmekammer 36 eingelegt werden. Dieses hat beispielsweise die Form eines blockförmigen Kontaktkörpers 18, der auf der nicht sichtbaren Unterseite Kontaktmittel 38 zur niederohmigen Kontaktierung auf einer Querverbindungsschiene, insbesondere einen Klemmdorn, und an der Stirnseite einen Kontakthohlraum 37 zum Eintritt eines bevorzugt stiftförmigen Zentrierkontaktteiles aufweist. Im eingelegten Zustand korrespondiert die Öffnung des Kontakthohlraumes 37 mit der Aufnahmeöffnung 35 im Kopfbereich 31 der Führungsschiene 15.

Figur 2c zeigt eine vorteilhafte Ausführung für ein zusätzliches Kontaktmittel 40 zwischen einem Aufnahmekontaktteil und einem Zentrierkontaktteil. Dieses kann vorteilhaft als eine Käfigfeder bzw. Tonnenfeder ausgeführt sein, welche in den Kontakthohlraum 37 des Aufnahmekontaktteiles 17 integrierbar ist. Die Käfigfeder 40 weist vorteilhaft auf eine vordere geschlitzte, zylinderförmige Hülse 41 und eine hintere geschlitzte, zylinderförmige Hülse 43, welche über nach innen gebogene Federkontaktlamellen 42 verbunden sind. Diese bilden einen verengten Kontaktkanal, welcher elektrisch leitend auf einem Zentrierkontaktteil aufliegt, das über den vorderen Einführbereich 44 in der Hülse 41 in das Kontaktmittel 40 eingetaucht ist.

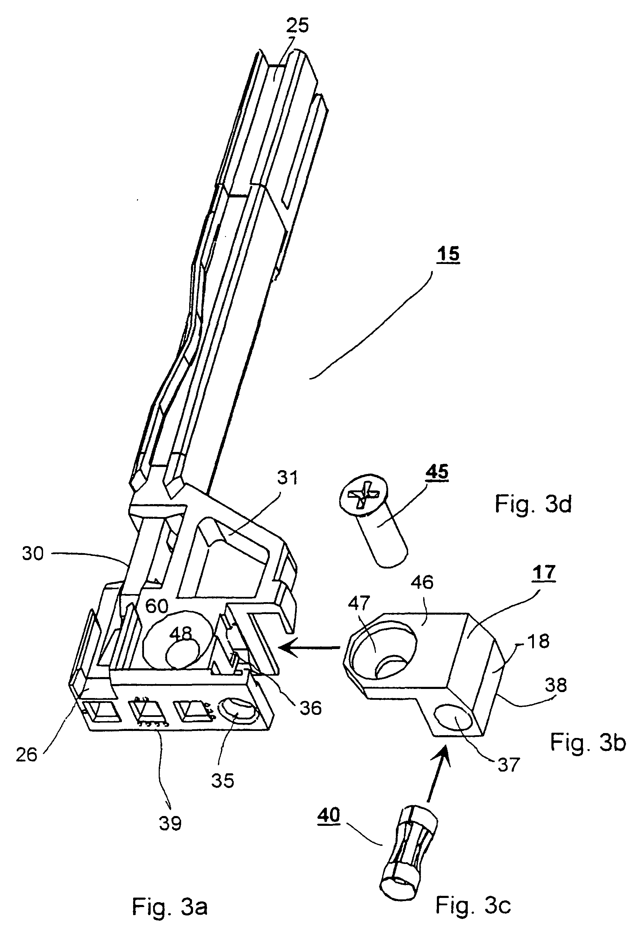

Mittels der Figuren 3a, 3b, 3c und 3d wird nachfolgend eine beispielhafte zweite Ausführungsform der Erfindung näher erläutert. Dabei zeigt Figur 3a eine der Figur 2a entsprechende perspektivische Draufsicht auf den Kopfbereich einer Führungsschiene, Figur 3b ein Aufnahmekontaktteil und Figur 3c ein der Figur 2c entsprechendes vorteilhaftes, zusätzliches Kontaktmittel zur Einlage in das Aufnahmekontaktteil. Figur 3d zeigt schließlich ein zusätzliches Verbindungsmittel für das Aufnahmekontaktteil mit einer Querverbindungsschiene.

Das in Figur 3b gezeigte Aufnahmekontaktteil 17 verfügt im Vergleich zum Aufnahmekontaktteil von Figur 2b über eine zusätzliche Befestigungslasche 46 am blockförmigen Kontaktkörper 18. Diese weist eine Durchgriffsöffnung 47 für ein Befestigungsmittel 45 auf, welches in Figur 3d beispielsweise als eine Schraube dargestellt ist. Das Befestigungsmittel 45 dient zur dauerhaften Befestigung des Aufnahmekontaktteiles 17 auf der Querverbindungsschiene. Gleichzeitig wird eine den Anforderungen an eine Schutzkontaktierung besonders gut entsprechende elektrisch niederohmige Kontaktierung mit besonders hoher Stromtragefähigkeit hergestellt.

Es ist besonders vorteilhaft, wenn gemäß Figur 3a der Kopfbereich 31 der Führungsschiene 15 so gestaltet ist, daß die Befestigungslasche 46 eines in die Aufnahmemulde 36 eingelegten Aufnahmekontaktteiles 17 auf der Oberseite 60 des Kopfbereiches 31 aufliegt und das Befestigungsmittel 45 sowohl durch die Durchgriffsöffnung 47 der Befestigungslasche 46 als auch durch eine korrespondierende Durchgriffsöffnung 48 im Kopfbereich 31 hindurch bis zu einer darunter liegenden Querverbindungsschiene hindurch greift. Hiermit kann eine sehr kompakte Halterung von Führungsschiene und Aufnahmekontaktteil auf einer Querverbindungsschiene erreicht werden.

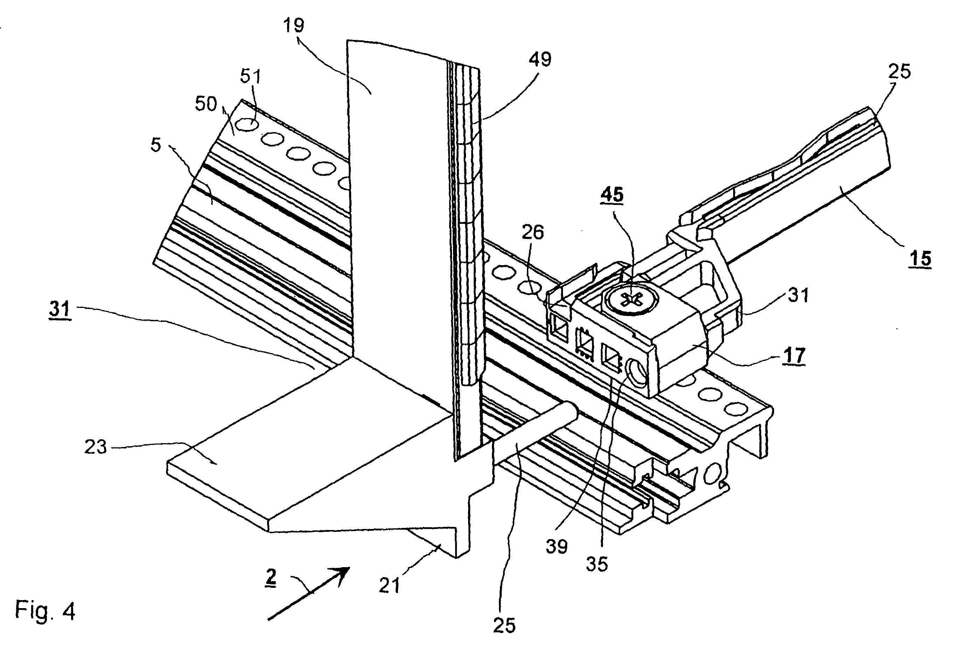

Eine derartige Anordnung ist im montierten Zustand in Figur 4 dargestellt. Auf der oberen Auflagefläche 50 einer ausschnittsweise gezeigten, vorderen unteren Querverbindungsschiene 5 ist die untere Führungsschienen 15 im Bereich von deren bevorzugt verbreiterten Kopfbereich 31 aufgelegt und vorzugsweise über Montagelöcher 51 mit der Querverbindungsschiene 5 verrastet. Ein Aufnahmekontaktteil 17 ist in der oben beschriebenen Weise in den Kopfbereich 31 der Führungsschiene 15 eingelegt. Eine als Verbindungsmittel dienende Schraube 45 greift sowohl durch das Aufnahmekontaktteil 17 als auch durch den darunter liegenden Kopfbereich 31 der Führungsschienen 15 hindurch und ist in einem der Montagelöcher 51 der Querverbindungsschiene 5 verschraubt.

Figur 4 zeigt ferner ausschnittsweise das Frontelement 13 für den Einbauplatz 57, welches zur besseren Übersicht nicht mit einer elektrischen Flachbaugruppe bestückt ist. Deren eine Längsseite ist mit einem zusätzlichen Kontaktfederstreifen 49 belegt. Das Frontelement 13 enthält eine Frontplatte 19 aus elektrisch leitendem Material, an deren unterem Ende ein unteres Endstück 21 mit einem unteren Hebelziehgriff 23 und einem unteren Zentrierkontaktteil 25. Dieses korrespondiert bei Auflegen des Frontelementes 13 auf der Einschubseite 2 des Baugruppenträgers so mit dem Aufnahmekontaktteil 17, daß dieses über die Aufnahmeöffnung 35 bis in Kontakthohlraum 37 eintaucht. Hiermit kann sowohl eine Ground-Kontaktierung des Frontelements 13 und einer gegebenenfalls damit verbundenen Flachbaugruppe, als auch eine mechanische Zentrierung bei einem Einschubvorgang bewirkt werden.

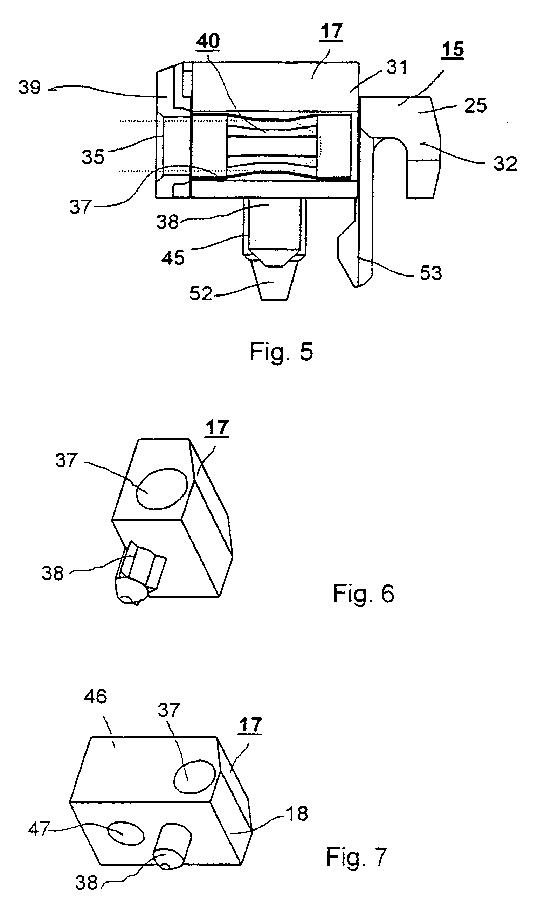

Figur 5 zeigt eine im Kopfbereich 31 der Führungsschiene 15 gelegene Schnittdarstellung durch ein Aufnahmekontaktteil 17 mit einem eingelegten Kontaktmittel 40. Die Ausführung entspricht dabei den Darstellungen in den Figuren 3a,3b,3c,3d und 4. Die Führungsschiene 15 weist unterhalb des Kopfbereiches 31 zumindest eine Eingriffsnoppe 52 auf, welche in ein Montageloch 51 auf einer Querverbindungsschiene eingreifen. Ferner ist unterhalb des Überganges zwischen Kopfbereich 31 und Verlängerungsbereich 32 der Führungsschiene 15 eine Rastnase 53 vorhanden, welche zum Hintergreifen einer Kante der Querverbindungsschiene dient. In Figur 5 ist desweiteren der Gewindeteil einer als gleichzeitiges Befestigungsmittel für Aufnahmekontaktteil 17 und Kopfbereich 31 der Führungsschiene dienenden Schraube 45 dargestellt. Schließlich ist im Schnitt das Aufnahmekontaktteil 17 zu erkennen, in dessen Kontakthohlraum 37 eine Tonnenfeder 40 als zusätzliches Kontaktmittel zwischen Aufnahmekontaktteil 17 und einem Zentrierkontaktmittel eingelegt ist. Das Aufnahmekontaktteil 17 weist auf der Unterseite ein weiteres Kontaktmittel 38 auf, welches insbesondere in Form eines Zapfens ebenfalls in ein Montageloch 51 auf der Querverbindungsschiene eingreift. Schließlich ist im Schnitt der Figur 5 zu erkennen, daß die Aufnahmeöffnung 35 in der Stirnseite 39 des Kopfbereiches 31 paßgenau zur Öffnung des Kontakthohlraumes 37 im dahinter liegenden Aufnahmekontaktteil 17 ist.

Figur 6 zeigt eine perspektivische Seitenansicht einer weiteren Ausführung eines Aufnahmekontaktteils 17, bei dem das Kontaktmittel 38 auf der Unterseite zusätzliche Widerhaken bzw. Schneidkanten aufweist. Hiermit wird der elektrische Kontakt zwischen Aufnahmekontaktteil und einer Querverbindungsschiene in einem Montageloch 51 verbessert. Figur 7 zeigt in perspektivischer Seitenansicht eine weitere Ausführung eines Aufnahmekontaktteils 17, bei dem der Kontaktkörper 18 sowohl den Kontakthohlraum 37 als auch die Durchgriffsöffnung 47 für ein Befestigungsmittel aufweist.

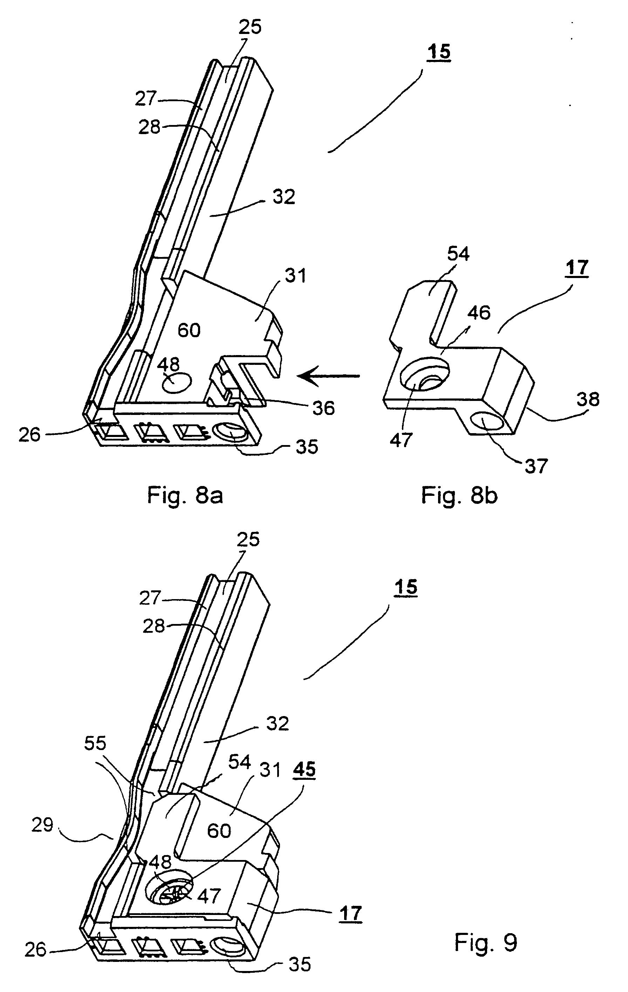

Die Figuren 8a, 8b zeigen in perspektivischen Draufsichten weitere Ausführungsformen einer Führungsschiene 15 und eines Aufnahmekontaktteiles 17. Soweit deren Ausführungen den Darstellungen in den Figuren 3a,3b,3c,3d und 4 entsprechen, wird auf die dazugehörigen, obigen Erläuterungen verwiesen. Zusätzlich weist aber die Ausführung des Aufnahmekontaktteiles 17 in Figur 8b erfindungsgemäß ein Kontaktmesser 54 auf. Im Beispiel der Figur 8b ist dieses vorteilhaft einteilig mit der Befestigungslasche 46 verbunden und in Richtung auf die Führungsnut 25 auf der Führungsschiene abgespreizt. Bei einer anderen, nicht dargestellten Ausführung kann dieses auch ein separates Teil darstellen, welches auf mechanische Weise mit dem Aufnahmekontaktteil 17 verbunden ist.

Bei dem in Figur 9 dargestellten, in die Aufnahmekammer 36 eingelegten Zustand des Aufnahmekontaktteiles 17 liegt das Kontaktmesser 54 auf der Oberseite 60 des Kopfstückes 31 der Führungsschiene 15 auf und reicht bis in deren Führungsnut 25 hinein. Vorteilhaft weist hierzu die rechte Nutwand 28 einen Durchbruch 55 auf. Wird nun in die Führungsnut 25 eine Flachbaugruppe eingeschoben, so wird diese in der Art einer ESD-Kontaktierung über das Kontaktmesser 54 des Aufnahmekontaktteiles 17 mit einer Querverbindungsschiene, dem Baugruppenträger und dessen Massekontaktmitteln verbunden. Die Verbindung erfolgt dabei vorteilhaft über eine Leitbahn am Rande der Flachbaugruppe, welche insbesondere während eines Einschiebe- oder Herausziehvorganges mit dem Kontaktmesser schleifend kontaktiert. Hiermit können elektrostatische Potentiale insbesondere von einem Frontelement 13 der Flachbaugruppe abgeleitet werden. Die in den Figuren 8a,8b und 9 dargestellte Ausführung der Erfindung weist somit den besonderen Vorteil auf, daß mit Hilfe eines einzigen, in eine Führungsschiene eingelegten Aufnahmekontaktteiles sowohl eine Groundals auch eine ESD-Kontaktierung zwischen Frontelementen und Baugruppenträger des erfindungsgemäßen Aufbausystems erzielt werden kann. Separate Schleifkontaktfedern im Nutgrund der Führungsnut entsprechend der in den DE 3624883 oder DE GM 295 09 185 beschriebenen Arten können somit entfallen.

Vorteilhaft ist eine der Nutwände einer Führungsnut, im Beispiel der Figuren 8a, 9 die linke Nutwand 27 der Führungsnut 25 auf der Führungsschiene 15, in einem dem Kontaktmesser 54 gegenüber liegenden Bereich 55 abschnittsweise vom Nutgrund getrennt und derartig als glockenkurvenförmige Blattfeder gestaltet, daß die Breite der Führungsnut 25 im Eingriffsbereich des Kontaktmessers 54 verjüngt ist. Hiermit kann die Kante einer Flachbaugruppe auf das Kontaktmesser gedrückt und z.B. eine auf der Flachbaugruppe befindliche Leiterbahn schleifend mit dem Kontaktmesser kontaktiert werden. Ferner kann auch bei der Ausführung der Figuren 8a, 8b ein zusätzliches Verbindungsmittel bevorzugt in Form einer Schraube vorgesehen sein, womit sowohl das Aufnahmekontaktteil 17 inklusive Kontaktmesser 54, als auch die Führungsschiene 15 insbesondere über deren Kopfbereich 31 mit einer darunter liegenden Querverbindungsschiene mechanisch und elektrisch leitend verbindbar ist. Im montierten Zustand, dargestellt in Figur 9, ist eine derartige Verbindungsschraube in die Durchgriffsöffnungen 47 und 48 des Aufnahmekontaktteiles 17 und der Führungsschiene 15 eingesetzt.

## Patentansprüche

1. Aufbausystem für elektrische Flachbaugruppen (58,59), mit
a) einem Baugruppenträger (1) mit Einbauplätzen (56,57) zum Einschub von elektrischen Flachbaugruppen (58,59), mit
a1) gegenüberliegenden Querverbindungsschienen (4,5;6,7) aus elektrisch leitendem Material,
a2) mit Führungsschienen (14,15) für den Einschub von Flachbaugruppen (58,59) in Einbauplätze (57), welche auf den Querverbindungsschienen (4,5;6,7) angebracht sind und eine Halteeinrichtung (36) aufweisen zur Einlage eines
a3) Aufnahmekontaktteils (16,17) aus elektrisch leitendem Material, das auf einer Querverbindungsschiene (4,5;6,7) niederohmig kontaktierbar ist und einen Kontaktbereich (37) aufweist, und mit
b) elektrisch leitenden Frontelementen (12,13), die jeweils einem Einbauplatz (57) zugeordnet sind und zumindest ein in Richtung auf die Einschubseite (2) des Baugruppenträgers (1) vorstehendes Zentrierkontaktteil (24,25) aufweisen, das bei Aufsetzen eines Frontelements (12,13) auf einen Einbauplatz (57) mit dem Kontaktbereich (37) des Aufnahmekontaktteils (17) elektrisch niederohmig und mit hoher Stromtragefähigkeit kontaktierbar ist.

2. Aufbausystem nach Anspruch 1, wobei eine Führungsschiene (14,15) eine bevorzugt muldenförmigen Aufnahmekammer als Halteeinrichtung (36) aufweist.

3. Aufbausystem nach Anspruch 1 oder 2, wobei eine Führungsschienen (14,15) an einer der Einschubseite (2) des Baugruppenträgers (1) zugewandten Stirnseite (39) eine Aufnahmeöffnung (35) für ein Zentrierkontaktteil (25) aufweist, welche in die Halteeinrichtung (36) für ein Aufnahmekontaktteil (16,17) mündet.

4. Aufbausystem nach einem der vorangegangenen Ansprüche, mit einem zusätzlichen Verbindungsmittel (45), insbesondere einer Schraubverbindung, zur elektrisch niederohmigen Befestigung eines Aufnahmekontaktteiles (17) auf einer Querverbindungsschiene (5).

5. Aufbausystem nach Anspruch 4, wobei das Verbindungsmittel (45) auch eine Fixierung der Führungsschiene (14,15) auf der Querverbindungsschiene (5) bewirkt.

6. Aufbausystem nach Anspruch 4 oder 5, wobei die Führungsschiene (14,15) eine bis zur Querverbindungsschiene (5) reichende Durchgriffsöffnung (48) für das Verbindungsmittel (45) des Aufnahmekontaktteiles (17) aufweist.

7. Aufbausystem nach Anspruch 4,5 oder 6, wobei die Aufnahmekontaktteile (16,17) aufweisen
a) einen den Kontaktbereich (37) für ein Zentrierkontaktteil (24,25) aufweisenden Kontaktkörper (18)
b) eine Befestigungslasche (46) für den Durchgriff des Verbindungsmittels (45).

8. Aufbausystem nach einem der vorangegangenen Ansprüche, wobei die Führungsschienen (14,15) zumindest einen bevorzugt verbreiterten Kopfbereich (31) aufweisen, welcher auf einer Querverbindungsschiene (4,5;6,7) aufliegt und in den die Halteeinrichtung (36) für ein Aufnahmekontaktteil (16,17) integriert ist.

9. Aufbausystem nach Anspruch 7, wobei die Führungsschienen (14,15) zumindest einen verbreiterten Kopfbereich (31) aufweisen, welcher auf einer Querverbindungsschiene (4,5;6,7) aufliegt und in den die Halteeinrichtung (36) für ein Aufnahmekontaktteil (16,17) derart integriert ist, daß die Befestigungslasche (46) des Aufnahmekontaktteiles (16,17) auf einer Oberseite (60) des Kopfbereiches (31) aufliegt und ein Verbindungsmittel (45) die Befestigungslasche (46) und den Kopfbereich (31) bis zur Querverbindungsschiene durchgreift.

10. Aufbausystem nach einem der vorangegangenen Ansprüche, mit einem zusätzlichen Kontaktmittel (40) zwischen einem Aufnahmekontaktteil (17) und einem Zentrierkontaktteil (25), insbesondere einer in das Aufnahmekontaktteil (17) integrierten Käfigfeder.

11. Aufbausystem nach einem der vorangegangenen Ansprüche, wobei ein Aufnahmekontaktteil (16,17) zusätzlich ein Kontaktmesser (54) aufweist, welches bis in eine Führungsnut (25) auf einer Führungsschiene (15) reicht und mit einer Flachbaugruppe (59) zur Ableitung elektrostatischer Potentiale, insbesondere von deren Frontelement (13), kontaktiert.

12. Aufbausystem für elektrische Flachbaugruppen (58,59), mit
a) einem Baugruppenträger (1) mit Einbauplätzen (56,57) zum Einschub von elektrischen Flachbaugruppen (58,59), mit
a1) gegenüberliegenden Querverbindungsschienen (4,5;6,7) aus elektrisch leitendem Material,
a2) mit Führungsschienen (14,15) für den Einschub von Flachbaugruppen (58,59) in Einbauplätze (57), welche auf den Querverbindungsschienen (4,5;6,7) angebracht sind, und
a3) zumindest einem Aufnahmekontaktteil (16,17) aus elektrisch leitendem Material, das einem Einbauplatz (56;57) zugeordnet und auf einer Querverbindungsschiene (4,5;6,7) niederohmig kontaktierbar ist, und einen Kontaktbereich (37) und ein bis in eine Führungsnut (25) der Führungsschiene (15) reichendes Kontaktmesser (54) aufweist, und
b) elektrisch leitenden Frontelementen (12,13) für Flachbaugruppen (58,59), die zumindest ein in Richtung auf die Einschubseite (2) des Baugruppenträgers (1) vorstehendes Zentrierkontaktteil (24,25) aufweisen, wobei bei Einschub der Flachbaugruppe (59) in einen Einbauplatz (57)
b1) das Zentrierkontaktteil (24,25) mit dem Kontaktbereich (37) des Aufnahmekontaktteiles (17) eines Einbauplatzes elektrisch niederohmig mit hoher Stromtragefähigkeit kontaktierbar ist, und
b2) das Kontaktmesser (54) eines Aufnahmekontaktteiles (17) zur Ableitung elektrostatischer Potentiale mit der Flachbaugruppe (59) kontaktiert.

13. Aufbausystem nach Anspruch 12, wobei eine Führungsschiene (14,15) eine Halteeinrichtung (36), bevorzugt eine muldenförmigen Aufnahmekammer, zur Einlage eines Aufnahmekontaktteiles (16,17) aufweist.

14. Aufbausystem nach Anspruch 12 oder 13, mit einem zusätzlichen Verbindungsmittel (45), insbesondere einer Schraubverbindung, zur elektrisch niederohmigen Befestigung eines Aufnahmekontaktteiles (17) auf einer Querverbindungsschiene (5).

15. Aufbausystem nach Anspruch 14, wobei das Verbindungsmittel (45) auch eine Fixierung der Führungsschiene (14,15) auf der Querverbindungsschiene (5) bewirkt.

16. Aufbausystem nach Anspruch 14 oder 15, wobei die Aufnahmekontaktteile (16,17) aufweisen
a) einen den Kontaktbereich (37) für ein Zentrierkontaktteil (24,25) aufweisenden Kontaktkörper (18) und
b) eine Befestigungslasche (46) für den Durchgriff des Verbindungsmittels (45).

17. Aufbausystem nach Anspruch 16, wobei das Kontaktmesser (54) einteilig mit der Befestigungslasche (46) eines Aufnahmekontaktteiles (16,17) verbunden ist.

18. Aufbausystem nach einem der Ansprüche 12 bis 17, wobei die Führungsnut (25) auf einer Führungsschiene (15) von Nutwänden (27,28) begrenzt wird, und eine dem Kontaktmesser (54) gegenüber liegende Nutwand (27) abschnittsweise vom Grund der Führungsnut (25) getrennt und derartig als glockenkurvenförmige Blattfeder gestaltet ist, daß die Breite der Führungsnut (25) im Bereich des Kontaktmessers (54) verjüngt ist.

19. Aufbausystem nach einem der vorangegangenen Ansprüche, mit Führungsschienen (14,15) aus elektrisch nicht leitendem Material.

## Claims

1. Mounting system for electrical printed circuit board assemblies (58, 59), having
a) a mounting rack (1) with installation slots (56, 57) for insertion of electrical printed circuit board assemblies (58, 59), having
a1) opposite transverse connecting rails (4, 5; 6, 7) composed of electrically conductive material,
a2) guide rails (14, 15) for the insertion of printed circuit board assemblies (58, 59) into installation slots (57), which are fitted on the transverse connecting rails (4, 5; 6, 7) and have a retaining device (36) for the insertion of a
a3) holding contact part (16, 17) composed of electrically conductive material, which can be made contact with, with a low impedance, on a transverse connecting rail (4, 5; 6, 7) and has a contact area (37), and having
b) electrically conductive front parts (12, 13) which are each associated with one installation slot (57) and have at least one centring contact part (24, 25) which projects in the direction of the insertion side (2) of the mounting rack (1) and can make contact with the contact area (37) of the holding contact part (17), with a low electrical impedance and with a high current carrying capacity, when a front element (12, 13) is fitted to an installation slot (57).

2. Mounting system according to Claim 1, with one guide rail (14, 15) having a holding chamber, preferably in the form of a trough, as the retaining device (36).

3. Mounting system according to Claim 1 or 2, with one guide rail (14, 15) having a holding opening (35) for a centring contact part (25) on an end face (39) which faces the insertion side (2) of the mounting rack (1), which holding opening (35) opens into the retaining device (36) for the holding contact part (16, 17).

4. Mounting system according to one of the preceding claims, having an additional connecting means (45), in particular a screw connection, in order to mount a holding contact part (17) with a low electrical impedance on a transverse connecting rail (5).

5. Mounting system according to Claim 4, with the connecting means (45) also acting as a fixing for the guide rail (14, 15) on the transverse connecting rail (5).

6. Mounting system according to Claim 4 or 5, with the guide rail (14, 15) having an aperture opening (48), which extends as far as the transverse connecting rail (5), for the connecting means (45) of the holding contact part (17).

7. Mounting system according to Claim 4, 5 or 6, with the holding contact parts (16, 17) having
a) a contact body (18) which has a contact area (37) for a centring contact part (24, 25), and
b) an attachment lug (46) for the connecting means (45) to pass through.

8. Mounting system according to one of the preceding claims, with the guide rails (14, 15) having at least one, preferably broader, head area (31), which rests on a transverse connecting rail (4, 5; 6, 7), and in which the retaining device (36) for a holding contact part (16, 17) is integrated.

9. Mounting system according to Claim 7, with the guide rails (14, 15) having at least one wider head area (31), which rests on a transverse connecting rail (4, 5; 6, 7) and in which the retaining device (36) for a holding contact part (16, 17) is integrated, such that the attachment lug (46) of the holding contact part (16, 17) rests on an upper face (60) of the head area (31), and a connecting means (45) passes through the attachment lug (46) and the head area (31) as far as the transverse connecting rail.

10. Mounting system according to one of the preceding claims, having an additional contact means (40) between a holding contact part (17) and a centring contact part (25), in particular a caged spring which is integrated in the holding contact part (17).

11. Mounting system according to one of the preceding claims, with one holding contact part (16, 17) additionally having a contact blade (54) which extends into a guide groove (25) on a guide rail (15) and makes contact with a printed circuit board assembly (59) in order to dissipate electrostatic potentials, in particular from its front element (13).

12. Mounting system for electrical printed circuit board assemblies (58, 59), having
a) a mounting rack (1) with installation slots (56, 57) for insertion of electrical printed circuit board assemblies (58, 59), having
a1) opposite transverse connecting rails (4, 5; 6, 7) composed of electrically conductive material,
a2) guide rails (14, 15) for the insertion of printed circuit board assemblies (58, 59) into installation slots (57), which are fitted on the transverse connecting rails (4, 5; 6, 7), and
a3) at least one holding contact part (16, 17) composed of electrically conductive material, which has an associated insertion slot (56; 57), can be made contact with, with a low impedance, on a transverse connecting rail (4, 5; 6, 7) and has a contact area (37) and a contact blade (54) which extends into a guide groove (25) in the guide rail (15), and
b) electrically conductive front elements (12, 13) for printed circuit board assemblies (58, 59), which have at least one centring contact part (24, 25) which projects in the direction of the insertion side (2) of the mounting rack (1) in which case, during insertion of the printed circuit board assembly (59) into an installation slot (57),
b1) the centring contact part (24, 25) can make contact with the contact area (37) of the holding contact part (17) of an installation slot with a low electrical impedance and with a high current carrying capacity, and
b2) the contact blade (54) of a holding contact part (17) makes contact with the printed circuit board assembly (59) in order to dissipate electrostatic potentials.

13. Mounting system according to Claim 12, with one guide rail (14, 15) having a retaining device (36), preferably a holding chamber in the form of a trough, for the insertion of a holding contact part (16, 17).

14. Mounting system according to Claim 12 or 13, having an additional connecting means (45), in particular a screw connection, for mounting a holding contact part (17) on a transverse connecting rail (5) with a low electrical impedance.

15. Mounting system according to Claim 14, with the connecting means (45) also acting as a fixing for the guide rail (14, 15) on the transverse connecting rail (5).

16. Mounting system according to Claim 14 or 15, with the holding contact parts (16, 17) having
a) a contact body (18) which has the contact area (37) for a centring contact part (24, 25), and
b) an attachment lug (46) for the connecting means (45) to pass through.

17. Mounting system according to Claim 16, with the contact blade (54) being integrally connected to the attachment lug (46) of a holding contact part (16, 17).

18. Mounting system according to one of Claims 12 to 17, with the guide groove (25) on a guide rail (15) being bounded by groove walls (27, 28), and a groove wall (27) which is located opposite the contact blade (54) being separated in places from the base of the guide groove (25), and being in the form of a bell-shaped leaf spring, such that the width of the guide groove (25) is tapered in the area of the contact blade (54).

19. Mounting system according to one of the preceding claims, having guide rails (14, 15) composed of electrically non-conductive material.

## Revendications

1. Système de montage pour cartes imprimées électriques (58, 59) comprenant
a) un support de cartes (1) muni d'emplacements de montage (56, 57) pour insérer des cartes imprimées électriques (58, 59), comprenant
a1) des rails de liaison transversaux (4, 5 ; 6, 7) opposés en matériau conducteur d'électricité,
a2) avec des rails de guidage (14, 15) pour l'insertion des cartes imprimées (58, 59) dans les emplacements de montage (57), lesquels sont montés sur les rails de liaison transversaux (4, 5 ; 6, 7) et présentent un dispositif de maintien (36) pour y loger un
a3) élément de contact femelle (16, 17) en matériau conducteur d'électricité qui peut être mis en contact à faible impédance avec un rail de liaison transversal (4, 5 ; 6, 7) et présente une zone de contact (37), et comprenant
b) des éléments frontaux (12, 13) conducteurs d'électricité qui sont à chaque fois associés à un emplacement de montage (57) et présentent au moins un élément de contact et de centrage (24, 25) en saillie en direction du côté insertion (2) du support de cartes (1), lequel peut être mis en contact électrique à faible impédance et à haute capacité de transport du courant avec la zone de contact (37) de l'élément de contact femelle (17) lors de la mise en place d'un élément frontal (12, 13) sur un emplacement de montage (57).

2. Système de montage selon la revendication 1, dans lequel un rail de guidage (14, 15) présente une chambre de réception de préférence en forme d'auge faisant office de dispositif de maintien (36).

3. Système de montage selon la revendication 1 ou 2, dans lequel un rail de guidage (14, 15) présente sur un côté frontal (39) dirigé vers le côté insertion (2) du support de cartes (1) un orifice d'accueil (35) pour un élément de contact et de centrage (25) qui débouche dans le dispositif de maintien (36) pour un élément de contact femelle (16, 17).

4. Système de montage selon l'une des revendications précédentes, comprenant un moyen de liaison supplémentaire (45), notamment une liaison par vis pour la fixation électrique à faible impédance d'un élément de contact femelle (17) sur un rail de liaison transversal (5).

5. Système de montage selon la revendication 4, dans lequel le moyen de liaison (45) réalise également une fixation du rail de guidage (14, 15) sur le rail de liaison transversal (5).

6. Système de montage selon la revendication 4 ou 5, dans lequel le rail de guidage (14, 15) présente une ouverture de pénétration (48) qui s'étend jusqu'au rail de liaison transversal (5) pour le moyen de liaison (45) de l'élément de contact femelle (17).

7. Système de montage selon la revendication 4, 5 ou 6, dans lequel les éléments de contact femelles (16, 17) présentent
a) un corps de contact (18) qui présente la zone de contact (37) pour un élément de contact et de centrage (24, 25),
b) une éclisse de fixation (46) pour la pénétration du moyen de liaison (45).

8. Système de montage selon l'une des revendications précédentes, dans lequel les rails de guidage (14, 15) présentent au moins une zone de tête (31) de préférence élargie qui repose sur un rail de liaison transversal (4, 5 ; 6, 7) et qui est intégrée dans le dispositif de maintien (36) pour un élément de contact femelle (16, 17).

9. Système de montage selon la revendication 7, dans lequel les rails de guidage (14, 15) présentent une zone de tête élargie (31) qui repose sur un rail de liaison transversal (4, 5 ; 6, 7) et qui est intégrée dans le dispositif de maintien (36) pour un élément de contact femelle (16, 17) de sorte que l'éclisse de fixation (46) de l'élément de contact femelle (16, 17) repose sur un côté supérieur (60) de la zone de tête (31) et un moyen de liaison (45) traverse l'éclisse de fixation (46) et la zone de tête (31) jusqu'au rail de liaison transversal.

10. Système de montage selon l'une des revendications précédentes, comprenant un moyen de contact supplémentaire (40) entre un élément de contact femelle (17) et un élément de contact et de centrage (25), notamment un ressort à cage intégré dans l'élément de contact femelle (17).

11. Système de montage selon l'une des revendications précédentes, dans lequel un élément de contact femelle (16, 17) présente en plus une lame de contact (54) qui s'étend jusqu'à une rainure de guidage (25) sur un rail de guidage (15) et entre en contact avec une carte imprimée (59) pour évacuer les potentiels électrostatiques, notamment depuis son élément frontal (13).

12. Système de montage pour cartes imprimées électriques (58, 59) comprenant
a) un support de cartes (1) muni d'emplacements de montage (56, 57) pour insérer des cartes imprimées électriques (58, 59), comprenant
a1) des rails de liaison transversaux (4, 5 ; 6, 7) opposés en matériau conducteur d'électricité,
a2) avec des rails de guidage (14, 15) pour l'insertion des cartes imprimées (58, 59) dans les emplacements de montage (57), lesquels sont montés sur les rails de liaison transversaux (4, 5 ; 6, 7), et
a3) au moins un élément de contact femelle (16, 17) en matériau conducteur d'électricité qui est associé à un emplacement de montage (56 ; 57) et qui peut être mis en contact à faible impédance avec un rail de liaison transversal (4, 5 ; 6, 7) et présente une zone de contact (37) et une lame de contact (54) qui s'étend dans une rainure de guidage (25) du rail de guidage (15), et
b) des éléments frontaux (12, 13) conducteurs d'électricité pour les cartes imprimées (58, 59) qui présentent au moins un élément de contact et de centrage (24, 25) en saillie en direction du côté insertion (2) du support de cartes (1), dans lequel lors de l'insertion de la carte imprimée (59) dans un emplacement de montage (57)
b1) l'élément de contact et de centrage (24, 25) peut entrer en contact électrique à faible impédance et à haute capacité de transport du courant avec la zone de contact (37) de l'élément de contact femelle (17) et
b2) la lame de contact (54) d'un élément de contact femelle (17) entre en contact avec la carte électrique (59) pour évacuer les potentiels électrostatiques.

13. Système de montage selon la revendication 12, dans lequel un rail de guidage (14, 15) présente un dispositif de maintien (36), de préférence une chambre de réception en forme d'auge pour y loger un élément de contact femelle (16, 17).

14. Système de montage selon la revendication 12 ou 13, comprenant un moyen de liaison supplémentaire (45), notamment une liaison par vis pour la fixation électrique à faible impédance d'un élément de contact femelle (17) sur un rail de liaison transversal (5).

15. Système de montage selon la revendication 14, dans lequel le moyen de liaison (45) réalise également une fixation du rail de guidage (14, 15) sur le rail de liaison transversal (5).

16. Système de montage selon la revendication 14 ou 15, dans lequel les éléments de contact femelles (16, 17) présentent
a) un corps de contact (18) qui présente la zone de contact (37) pour un élément de contact et de centrage (24, 25), et
b) une éclisse de fixation (46) pour la pénétration du moyen de liaison (45).

17. Système de montage selon la revendication 16, dans lequel la lame de contact (54) est reliée d'une seule pièce avec l'éclisse de fixation (46) d'un élément de contact femelle (16, 17).

18. Système de montage selon l'une des revendications 12 à 17, dans lequel la rainure de guidage (25) sur un rail de guidage (15) est délimitée par des parois de rainure (27, 28) et une paroi de rainure (27) à l'opposé de la lame de contact (54) est séparée par sections du fond de la rainure de guidage (25) et configurée sous la forme d'une lame de ressort en forme de courbe en cloche de sorte que la largeur de la rainure de guidage (25) se rétrécit dans la zone de la lame de contact (54).

19. Système de montage selon l'une des revendications précédentes, comprenant des rails de guidage (14, 15) en matériau non conducteur d'électricité.
